# EUROPEAN PATENT APPLICATION

(11) **EP 4 564 670 A1**
(43) Date of publication of application: **04.06.2025**
(21) Application number: 24215877.2
(22) Date of filing: 27.11.2024
(51) Int. Cl.: H03K 17/06, H03M 1/12

(54) **BOOTSTRAPPED SWITCH FOR STATIC BIAS VOLTAGE**

(30) Priority: 28.11.2023 US 202363603124 P; 26.11.2024 US 202418959670
(71) Applicant: MediaTek Inc., Hsinchu City, 30078 (TW)
(72) Inventor: SHU, Yun-Shiang, 30078 Hsinchu City (TW); HUNG, Tsung-Chih, 30078 Hsinchu City (TW); WENG, Chan-Hsiang, 30078 Hsinchu City (TW)
(74) Representative: Haseltine Lake Kempner LLP

(57) **Abstract**

A bootstrapped switch includes a first transistor, a capacitor, a first voltage providing circuit, and a second voltage providing circuit. Regarding the first transistor, a first connection terminal receives a static bias voltage, and a second connection terminal generates an output voltage. A first end of the capacitor is coupled to a control terminal of the first transistor. The first voltage providing circuit provides a first voltage to a second end of the capacitor during a first period in which the first transistor is turned off, and provides a second voltage to the second end of the capacitor during a second period in which the first transistor is turned on. The second voltage providing circuit provides a boost voltage to the control terminal of the first transistor during the first period, and stops providing the boost voltage to the control terminal of the first transistor during the second period.

## Description

This application claims the benefit of U.S. Provisional Application No. 63/603,124, filed on November 28th, 2023. The content of the application is incorporated herein by reference.

### BACKGROUND

The present invention relates to a bootstrapped switch design, and more particularly, to a bootstrapped switch that receives an input voltage being a static bias voltage (i.e., a constant voltage) and has fast ON/OFF speed.

Metal-oxide-semiconductor (MOS) transistors have been used as MOS switches, particularly for analog signals. In the early days of analog sampling, it was discovered that such MOS switches exhibit an input-dependent on-resistance, thereby introducing distortion. This issue can be resolved by "bootstrapping," a circuit technique that minimizes the MOS switch on-resistance variation in the presence of a large input voltage swing. Due to inherent characteristics of the bootstrapping technique, a gate voltage of the MOS switch may be higher than the supply voltage, which may cause a reliability issue. Hence, a conventional bootstrapped switch employs a complex design for achieving the bootstrapping function while addressing the reliability issue. Operations of the conventional bootstrapped switch with the complex design may include charging, discharging, and charge sharing. The switching speed of the conventional bootstrapped switch with the complex design depends on the MOS resistance and the parasitic capacitance and resistance. One way to increase the switching speed of the conventional bootstrapped switch is increasing device sizes for MOS on-resistance reduction. However, increasing device sizes may result in increased parasitic capacitance. As a result, there is limitation on the switching speed of the conventional bootstrapped switch with the complex design. For certain high-speed applications, most MOS switches may have input voltages being static bias voltages. Implementing a MOS switch for a static bias voltage by using the conventional bootstrapped switch with the complex design may fail to meet the switching speed requirement of a high-speed application. Thus, there is a need for an innovative bootstrapped switch with a simplified design that can provide fast switching speed (i.e., fast ON/OFF speed) under a condition that an input voltage of the bootstrapped switch is a static bias voltage (i.e., a constant voltage) rather a dynamic voltage.

### SUMMARY

One of the objectives of the claimed invention is to provide a bootstrapped switch that receives an input voltage being a static bias voltage (i.e., a constant voltage) and has fast ON/OFF speed.

According to one aspect of the present invention, an exemplary bootstrapped switch is disclosed. The exemplary bootstrapped switch includes a first transistor, a capacitor, a first voltage providing circuit, and a second voltage providing circuit. The first transistor includes a first connection terminal, a second connection terminal, and a control terminal. The first connection terminal is arranged to receive an input voltage of the bootstrapped switch, wherein the input voltage is a static bias voltage. The second connection terminal is arranged to generate an output voltage of the bootstrapped switch. The capacitor has a first end and a second end, wherein the first end is coupled to the control terminal of the first transistor. The first voltage providing circuit is coupled to the second end of the capacitor. The first voltage providing circuit is arranged to provide a first voltage to the second end of the capacitor during a first period in which the first transistor is turned off, and provide a second voltage to the second end of the capacitor during a second period in which the first transistor is turned on, where the second voltage is different from the first voltage. The second voltage providing circuit is coupled to the control terminal of the first transistor. The second voltage providing circuit is arranged to provide a boost voltage to the control terminal of the first transistor during the first period in which the first transistor is turned off, and stop providing the boost voltage to the control terminal of the first transistor during the second period in which the first transistor is turned on.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG. 1 is a circuit diagram of a first bootstrapped switch according to an embodiment of the present invention.
FIG. 2 is a diagram illustrating an equivalent circuit of the bootstrapped circuit that operates in a "Switch OFF (CK=Low)" phase according to an embodiment of the present invention.
FIG. 3 is a diagram illustrating an equivalent circuit of the bootstrapped circuit that operates in a "Switch ON (CK=High)" phase according to an embodiment of the present invention.
FIG. 4 is a diagram illustrating a configuration of the bootstrapped circuit that operates in the "Switch OFF (CK=Low)" phase according to an embodiment of the present invention.
FIG. 5 is a diagram illustrating a configuration of the bootstrapped circuit that operates in the "Switch ON (CK=High)" phase according to an embodiment of the present invention.
FIG. 6 is a circuit diagram of a second bootstrapped switch according to an embodiment of the present invention.
FIG. 7 is a circuit diagram of a third bootstrapped switch according to an embodiment of the present invention.
FIG. 8 is a circuit diagram of a fourth bootstrapped switch according to an embodiment of the present invention.
FIG. 9 is a circuit diagram of a fifth bootstrapped switch according to an embodiment of the present invention.
FIG. 10 is a circuit diagram of a sixth bootstrapped switch according to an embodiment of the present invention.
FIG. 11 is a circuit diagram of a seventh bootstrapped switch according to an embodiment of the present invention.
FIG. 12 is a circuit diagram of an eighth bootstrapped switch according to an embodiment of the present invention.
FIG. 13 is a diagram of a sample-and-hold (S/H) circuit according to an embodiment of the present invention.

### DETAILED DESCRIPTION

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

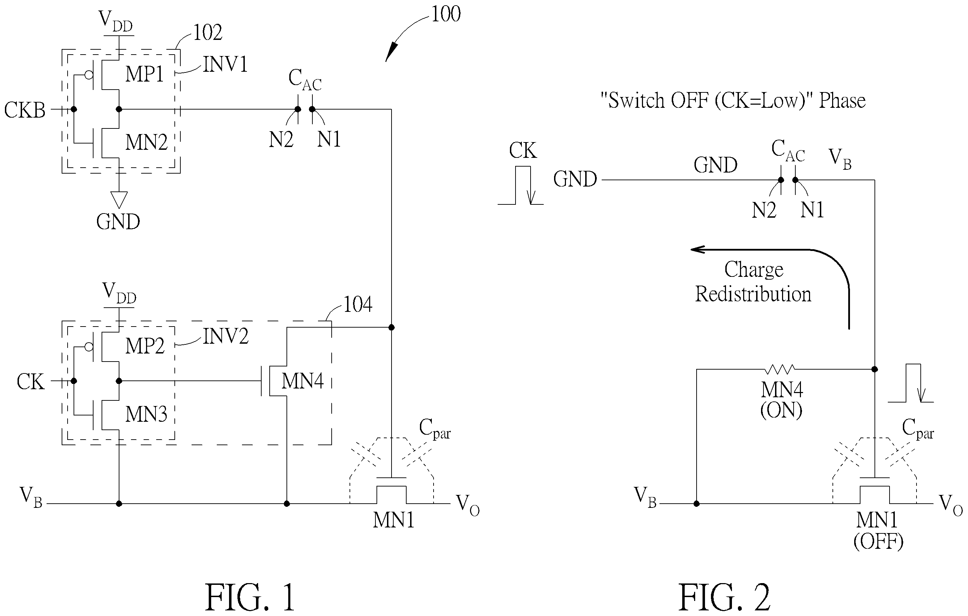

FIG. 1 is a circuit diagram of a first bootstrapped switch according to an embodiment of the present invention. The bootstrapped switch 100 includes a plurality of MOS transistors MN1, MN2, MN3, MN4, MP1, MP2 and a capacitor C_{AC}, where the MOS transistors MN1-MN4 are N-type MOS (NMOS) transistors, and the MOS transistors MP1-MP2 are P-type MOS (PMOS) transistors. The MOS transistor MN1 acts as a main MOS switch of the bootstrapped switch 100. Hence, the MOS transistor MN1 is arranged to receive an input voltage of the bootstrapped switch 100. When the MOS transistor MN1 is turned on, the MOS transistor MN1 is arranged to generate an output voltage V_{O} of the bootstrapped switch 100 according to the input voltage of the bootstrapped switch 100. In this embodiment, the input voltage of the bootstrapped switch 100 is a static bias voltage V_{B}. Specifically, the static bias voltage V_{B} is a constant voltage rather than a dynamic voltage that changes with time. Compared to the complex design of the conventional bootstrapped switch, the simplified design of the proposed bootstrapped switch 100 requires fewer transistors and therefore occupies a smaller chip area and has lower power consumption. Further details of the proposed bootstrapped switch 100 are described as below.

The MOS transistor MN1 has a first connection terminal (e.g., source) arranged to receive the static bias voltage V_{B} (which is the input voltage of the bootstrapped switch 100), a second connection terminal (e.g., drain) arranged to generate the output voltage V_{O} of the bootstrapped switch 100, and a control terminal (e.g., gate) coupled to a first end N1 of the capacitor C_{AC}. In addition to a main MOS switch (i.e., MOS transistor MN1) and an alternating-current (AC) coupling capacitor (i.e., capacitor C_{AC}), the bootstrapped switch 100 has a first voltage providing circuit 102 and a second voltage providing circuit 104.

In this embodiment, the first voltage providing circuit 102 is implemented by an inverter circuit INV1 that includes MOS transistors MP1 and MN2. The first voltage providing circuit 102 is coupled to a second end N2 of the capacitor C_{AC}. The first voltage providing circuit 102 is arranged to provide a first voltage (e.g., ground voltage GND) to the second end N2 of the capacitor C_{AC} during a first period in which the MOS transistor MN1 is turned off, and provide a second voltage (e.g., supply voltage V_{DD}) to the second end N2 of the capacitor C_{AC} during a second period in which the MOS transistor MN1 is turned on. The first voltage (e.g., GND) and the second voltage (e.g., V_{DD}) are reference voltages, and the second voltage (e.g., V_{DD}) is higher than the first voltage (e.g., GND). Regarding the inverter circuit INV1, the MOS transistor MP1 has a first connection terminal (e.g., source) arranged to receive the second voltage (e.g., V_{DD}), a second connection terminal (e.g., drain) coupled to the second end N2 of the capacitor C_{AC}, and a control terminal (e.g., gate) arranged to receive a clock signal CKB; and the MOS transistor MN2 has a first connection terminal (e.g., source) arranged to receive the first voltage (e.g., GND), a second connection terminal (e.g., drain) coupled to the second end N2 of the capacitor C_{AC}, and a control terminal (e.g., gate) arranged to receive the clock signal CKB. In this embodiment, the clock signal CKB is an inverted clock generated from inverting a clock signal CK (i.e., CKB =C̅K̅).

The second voltage providing circuit 104 is implemented by an inverter circuit INV2 and the MOS transistor MN4, where the inverter circuit INV2 includes MOS transistors MP2 and MN3. The second voltage providing circuit 104 is coupled to the control terminal (e.g., gate) of the MOS transistor MN1. The second voltage providing circuit 104 is arranged to provide a boost voltage to the control terminal (e.g., gate) of the MOS transistor MN1 during the first period in which the MOS transistor MN1 is turned off, and stop providing the boost voltage to the control terminal (e.g., gate) of the MOS transistor MN1 during the second period in which the MOS transistor MN1 is turned on. In this embodiment, the boost voltage is a fixed voltage that is set by the static bias voltage V_{B}. Regarding the inverter circuit INV2, the MOS transistor MP2 has a first connection terminal (e.g., source) arranged to receive the second voltage (e.g., V_{DD}), a second connection terminal (e.g., drain), and a control terminal (e.g., gate) arranged to receive the clock signal CK; and the MOS transistor MN3 has a first connection terminal (e.g., source) arranged to receive the static bias voltage V_{B}, a second connection terminal (e.g., drain), and a control terminal (e.g., gate) arranged to receive the clock signal CK. The MOS transistor MN4 has a first connection terminal (e.g., source) arranged to receive the static bias voltage V_{B}, a second connection terminal (e.g., drain) coupled to the control terminal (e.g., gate) of the MOS transistor MN1, and a control terminal (e.g., gate) coupled to the second connection terminal (e.g., drain) of the MOS transistor MP2 and the second connection terminal (e.g., drain) of the MOS transistor MN3.

As shown in FIG. 1, an input signal of the inverter INV1 is the clock signal CKB, and an input signal of the inverter circuit INV2 is the clock signal CK. In this embodiment, the MOS transistor MN1 is turned off during the first period in which the clock signal CK is low (e.g., CK=GND) and the clock signal CKB is high (e.g., CKB=V_{DD}), and is turned on during the second period in which the clock signal CK is high (e.g., CK=V_{DD}) and the clock signal CKB is low (e.g., CKB=GND). Please refer to FIG. 2 in conjunction with FIG. 1. FIG. 2 is a diagram illustrating an equivalent circuit of the bootstrapped circuit 100 that operates in a "Switch OFF (CK=Low) " phase according to an embodiment of the present invention. When the clock signal CK is low, an output signal of the inverter circuit INV2 is set by the second voltage (e.g., V_{DD}) due to the fact that the MOS transistor MP2 is turned on and the MOS transistor MN3 is turned off, and the MOS transistor MN4 is turned on due to its gate voltage set by the second voltage (e.g., V_{DD}) output from the inverter circuit INV2. The MOS transistor MN1 is turned off due to its gate-source voltage V_{gs} not larger than a threshold voltage Vₜₕ. In addition, the static bias voltage V_{B} is coupled to the first end N1 of the capacitor C_{AC} through the turned-on MOS transistor MN4. When the clock signal CKB is high, an output signal of the inverter circuit INV1 is set by the first voltage (e.g., GND) due to the fact that the MOS transistor MP1 is turned off and the MOS transistor MN2 is turned on. Hence, the first voltage (e.g., GND) is coupled to the second end N2 of the capacitor C_{AC} through the turned-on MOS transistor MN2. It should be noted that, compared to the complex design of the conventional bootstrapped switch that connects a gate terminal of a main MOS switch to a discharging path, the simplified design of the proposed bootstrapped switch 100 has no discharging path for parasitic capacitors Cₚₐᵣ of the MOS transistor MN1, and instead couples the AC-coupling capacitor C_{AC} to the parasitic capacitors Cₚₐᵣ of the MOS transistor MN1 for enabling charge redistribution. In this way, a direct-current (DC) voltage (V_{B}-GND) across the capacitor C_{AC} is built. Since most charge stored in the parasitic capacitors Cₚₐᵣ of the MOS transistor MN1 is not discharged via a discharging path, the static bias voltage V_{B} is only required to compensate for a small amount of charge lost due to leakage or other factors. Since most charge is preserved, the static bias voltage V_{B} is allowed to compensate for the small amount of lost charge slowly. In other words, the simplified design of the proposed bootstrapped switch 100 does not require low on-resistance of the MOS transistor MN4 to rebuild the DC voltage in a short period of time. In this way, the chip area of the proposed bootstrapped switch 100 can be further reduced by the MOS transistor MN4 implemented using a smaller-sized MOS transistor with higher on-resistance.

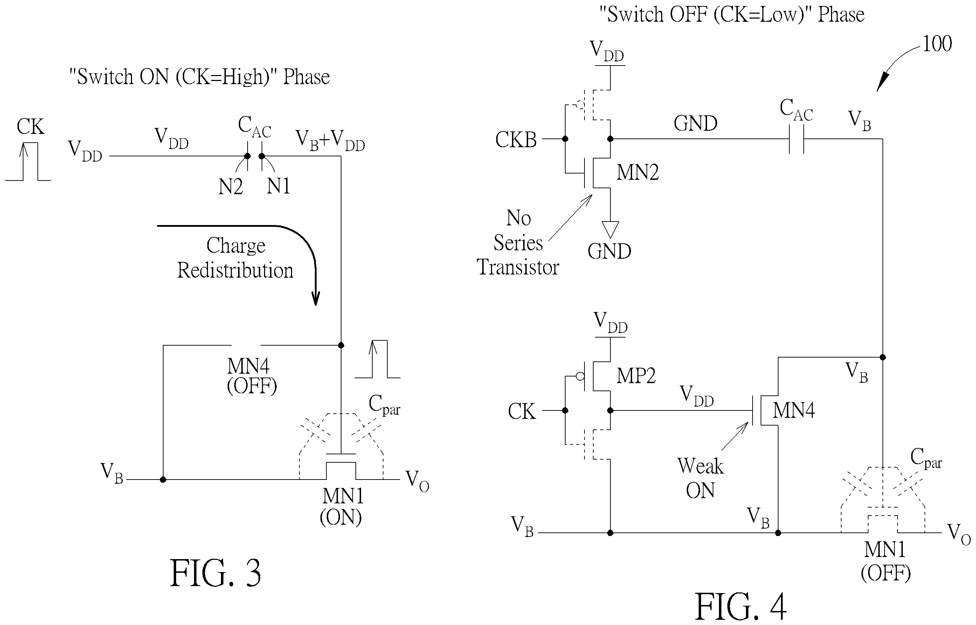

Please refer to FIG. 3 in conjunction with FIG. 1. FIG. 3 is a diagram illustrating an equivalent circuit of the bootstrapped circuit 100 that operates in a "Switch ON (CK=High) " phase according to an embodiment of the present invention. When the clock signal CK is high, an output signal of the inverter circuit INV2 is set by the static bias voltage V_{B} due to the fact that the MOS transistor MP2 is turned off and the MOS transistor MN3 is turned on, and the MOS transistor MN4 is turned off due to its gate voltage set by the static bias voltage V_{B} output from the inverter circuit INV2. When the clock signal CKB is low, an output signal of the inverter circuit INV1 is set by the second voltage (e.g., V_{DD}) due to the fact that the MOS transistor MP1 is turned on and the MOS transistor MN2 is turned off. Hence, the second voltage (e.g., V_{DD}) is coupled to the second end N2 of the capacitor C_{AC} through the turned-on MOS transistor MP1. As mentioned above, when the bootstrapped circuit 100 operates in the "Switch OFF (CK=Low)" phase, the DC voltage (V_{B}-GND) is built between first end N1 and second N2 of the capacitor C_{AC}. When the bootstrapped circuit 100 operates in the "Switch ON (CK=High)" phase, the first end N1 of the capacitor C_{AC} is isolated from the static bias voltage V_{B} and a voltage level of the second end N2 of the capacitor C_{AC} is increased from GND to V_{DD}. Hence, charge redistribution occurs between the capacitor C_{AC} and parasitic capacitors Cₚₐᵣ, and a voltage level of the first end N1 of the capacitor C_{AC} is increased from V_{B} to (V_{B}+V_{DD}). In addition to the second voltage (e.g., V_{DD}), a boost voltage (e.g., V_{B}) is applied to the control terminal (e.g., gate) of the MOS transistor MN1. The gate voltage of the MOS transistor MN1 is boosted via AC coupling. Specifically, the MOS transistor MN1 is turned on under a condition that its gate voltage is higher than the second voltage (e.g., V_{DD}) and its gate-source voltage V_{gs} is set by a fixed voltage being the second voltage (e.g., V_{DD}).

The simplified design of the proposed bootstrapped switch 100 can achieve enhancement of switching speed. FIG. 4 is a diagram illustrating a configuration of the bootstrapped circuit 100 that operates in the "Switch OFF (CK=Low)" phase according to an embodiment of the present invention. Since the static bias voltage V_{B} is higher than the first voltage (e.g., GND), the MOS transistor MN4 may operate in a weak ON state. Compared to the complex design of the conventional bootstrapped switch that has series transistors between the control terminal of the MOS transistor MN1and the ground to discharge Cₚₐᵣ from (V_{DD}+V_{B}) to GND, the simplified design of the proposed bootstrapped switch 100 has the second end N2 of the capacitor C_{AC} coupled to the first voltage (e.g., GND) through only a single MOS transistor MN2 to have the terminal of the MOS transistor MN1 drop from (V_{DD}+V_{B}) to V_{B} (V_{B} > GND) through the charge redistribution between Cₚₐᵣ and C_{AC}, where (V_{DD}+V_{B}) is set by the "Switch ON (CK=High) " phase preceding the "Switch OFF (CK=Low) " phase. Hence, the simplified design of the proposed bootstrapped switch 100 has fast OFF speed and is less sensitive to jitter. For example, the proposed bootstrapped switch 100 with less jitter is suitable for a sampling network in a high-speed application.

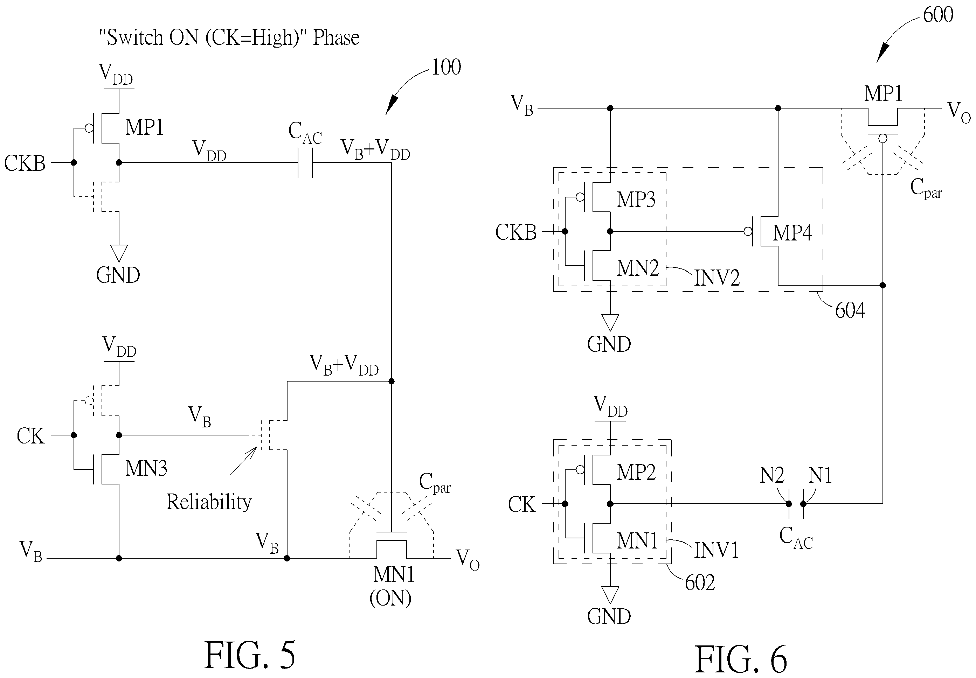

FIG. 5 is a diagram illustrating a configuration of the bootstrapped circuit 100 that operates in the "Switch ON (CK=High)" phase according to an embodiment of the present invention. Since the static bias voltage V_{B} is higher than the first voltage (e.g., GND), the MOS transistor MN4 has no reliability issue due to the fact that voltage difference between two terminals of the MOS transistor MN4 does not exceed the second voltage (e.g., V_{DD}). For example, the MOS transistor MN4 may be implemented by a thin oxide device (also called core device) . Furthermore, compared to the complex design of the conventional bootstrapped switch that requires additional transistors (particularly, two transistors and one capacitor connected in series) on a critical path between the source terminal and the gate terminal of the main MOS switch to increase the gate terminal of the main MOS switch from GND to (V_{B}+V_{DD}) (meanwhile, Cₚₐᵣ is charged from GND to (V_{B}+V_{DD})), the simplified design of the proposed bootstrapped switch 100 has no additional transistors (particularly, only one transistor MP1 and one capacitor C_{AC} connected in series between V_{DD} and the gate terminal of the main MOS switch) on a critical path that increases the gate terminal of the main MOS switch from V_{B} (V_{B} > GND) to (V_{B}+V_{DD}) (meanwhile, Cₚₐᵣ is charged from V_{B} to (V_{B}+V_{DD})), where V_{B} is set by the "Switch OFF (CK=Low)" phase preceding the "Switch ON (CK=High)" phase. Hence, the simplified design of the proposed bootstrapped switch 100 has fast ON speed.

As shown in FIG. 4, the MOS transistor MN4 is required to be turned on in the "Switch OFF (CK=Low)" phase, where the static bias voltage V_{B} is higher than the first voltage (e.g., GND), and the gate-source voltage V_{gs} of the MOS transistor MN4 is equal to (V_{DD}-V_{B}). The bootstrapped switch 100 shown in FIG. 1 is suitable for a low bias voltage input. If the static bias voltage V_{B} is too high, it is possible that the MOS transistor MN4 is unable to operate in an ON state. To address this issue, the present invention further proposes another bootstrapped switch that is suitable for a high bias voltage input. The same design concept of the bootstrapped switch 100 for a low bias voltage input may also be employed by the bootstrapped switch for a high bias voltage input.

FIG. 6 is a circuit diagram of a second bootstrapped switch according to an embodiment of the present invention. The bootstrapped switch 600 includes a plurality of MOS transistors MP1, MP2, MP3, MP4, MN1, MN2 and a capacitor C_{AC}, where the MOS transistors MP1-MP4 are PMOS transistors, and the MOS transistors MN1-MN2 are NMOS transistors. The MOS transistor MP1 acts as a main MOS switch of the bootstrapped switch 600. Hence, the MOS transistor MP1 is arranged to receive an input voltage of the bootstrapped switch 600. When the MOS transistor MP1 is turned on, the MOS transistor MP1 is arranged to generate an output voltage V_{O} of the bootstrapped switch 600 according to the input voltage of the bootstrapped switch 600. In this embodiment, the input voltage of the bootstrapped switch 600 is a static bias voltage V_{B}. Specifically, the static bias voltage V_{B} is a constant voltage rather a dynamic voltage that changes with time.

The MOS transistor MP1 has a first connection terminal (e.g., source) arranged to receive the static bias voltage V_{B} (which is the input voltage of the bootstrapped switch 600), a second connection terminal (e.g., drain) arranged to generate the output voltage V_{O} of the bootstrapped switch 600, and a control terminal (e.g., gate) coupled to a first end N1 of the capacitor C_{AC}. In addition to a main MOS switch (i.e., MOS transistor MP1) and an AC-coupling capacitor (i.e. , capacitor C_{AC}), the bootstrapped switch 600 has a first voltage providing circuit 602 and a second voltage providing circuit 604.

In this embodiment, the first voltage providing circuit 602 is implemented by an inverter circuit INV1 that includes MOS transistors MN1 and MP2. The first voltage providing circuit 602 is coupled to a second end N2 of the capacitor C_{AC}. The first voltage providing circuit 602 is arranged to provide a first voltage (e.g., supply voltage V_{DD}) to the second end N2 of the capacitor C_{AC} during a first period in which the MOS transistor MP1 is turned off, and provide a second voltage (e.g., ground voltage GND) to the second end N2 of the capacitor C_{AC} during a second period in which the MOS transistor MP1 is turned on. The first voltage (e.g., V_{DD}) and the second voltage (e.g., GND) are reference voltages, and the second voltage (e.g., GND) is lower than the first voltage (e.g., V_{DD}). Regarding the inverter circuit INV1, the MOS transistor MN1 has a first connection terminal (e.g., source) arranged to receive the second voltage (e.g., GND), a second connection terminal (e.g., drain) coupled to the second end N2 of the capacitor C_{AC}, and a control terminal (e.g., gate) arranged to receive a clock signal CK; and the MOS transistor MP2 has a first connection terminal (e.g., source) arranged to receive the first voltage (e.g., V_{DD}), a second connection terminal (e.g., drain) coupled to the second end N2 of the capacitor C_{AC}, and a control terminal (e.g., gate) arranged to receive the clock signal CK.

The second voltage providing circuit 604 is implemented by an inverter circuit INV2 and the MOS transistor MP4, where the inverter circuit INV2 includes MOS transistors MN2 and MP3. The second voltage providing circuit 604 is coupled to the control terminal (e.g., gate) of the MOS transistor MP1. The second voltage providing circuit 604 is arranged to provide a boost voltage to the control terminal (e.g., gate) of the MOS transistor MP1 during the first period in which the MOS transistor MP1 is turned off, and stop providing the boost voltage to the control terminal (e.g., gate) of the MOS transistor MP1 during the second period in which the MOS transistor MP1 is turned on. In this embodiment, the boost voltage is a fixed voltage that is set by the static bias voltage V_{B}. Regarding the inverter circuit INV2, the MOS transistor MN2 has a first connection terminal (e.g., source) arranged to receive the second voltage (e.g., GND), a second connection terminal (e.g., drain), and a control terminal (e.g., gate) arranged to receive a clock signal CKB; and the MOS transistor MP3 has a first connection terminal (e.g., source) arranged to receive the static bias voltage V_{B}, a second connection terminal (e.g., drain), and a control terminal (e.g., gate) arranged to receive the clock signal CKB. In this embodiment, the clock signal CKB is an inverted clock generated from inverting the clock signal CK (i.e., CKB = C̅K̅). The MOS transistor MP4 has a first connection terminal (e.g., source) arranged to receive the static bias voltage V_{B}, a second connection terminal (e.g., drain) coupled to the control terminal (e.g., gate) of the MOS transistor MP1, and a control terminal (e.g., gate) coupled to the second connection terminal (e.g., drain) of the MOS transistor MN2 and the second connection terminal (e.g., drain) of the MOS transistor MP3.

As shown in FIG. 6, an input signal of the inverter INV1 is the clock signal CK, and an input signal of the inverter circuit INV2 is the clock signal CKB. In this embodiment, the MOS transistor MP1 is turned off during the first period in which the clock signal CK is low (e.g., CK=GND) and the clock signal CKB is high (e.g., CKB=V_{DD}), and is turned on during the second period in which the clock signal CK is high (e.g., CK=V_{DD}) and the clock signal CKB is low (e.g., CKB=GND). When the bootstrapped circuit 600 operates in a "Switch OFF (CK=Low)" phase, an output signal of the inverter circuit INV2 is set by the second voltage (e.g., GND) due to the fact that the MOS transistor MN2 is turned on and the MOS transistor MP3 is turned off, and the MOS transistor MP4 is turned on due to its gate voltage set by the second voltage (e.g., GND) output from the inverter circuit INV2. The MOS transistor MP1 is turned off due to its gate-source voltage V_{gs} not smaller than a threshold voltage -Vₜₕ. In addition, the static bias voltage V_{B} is coupled to the first end N1 of the capacitor C_{AC} through the turned-on MOS transistor MP4. When the bootstrapped circuit 600 operates in the "Switch OFF (CK=Low)" phase, an output signal of the inverter circuit INV1 is set by the first voltage (e.g., V_{DD}) due to the fact that the MOS transistor MN1 is turned off and the MOS transistor MP2 is turned on. Hence, the first voltage (e.g., V_{DD}) is coupled to the second end N2 of the capacitor C_{AC} through the turned-on MOS transistor MP2. In this way, a DC voltage (V_{B}-V_{DD}) across the capacitor C_{AC} is built.

When the bootstrapped circuit 600 operates in a "Switch ON (CK=High) " phase, an output signal of the inverter circuit INV2 is set by the static bias voltage V_{B} due to the fact that the MOS transistor MN2 is turned off and the MOS transistor MP3 is turned on, and the MOS transistor MP4 is turned off due to its gate voltage set by the static bias voltage V_{B} output from the inverter circuit INV2. When the bootstrapped circuit 600 operates in the "Switch ON (CK=High)" phase, an output signal of the inverter circuit INV1 is set by the second voltage (e.g., GND) due to the fact that the MOS transistor MN1 is turned on and the MOS transistor MP2 is turned off. Hence, the second voltage (e.g., GND) is coupled to the second end N2 of the capacitor C_{AC} through the turned-on MOS transistor MN1. As mentioned above, when the bootstrapped circuit 100 operates in the "Switch OFF (CK=Low)" phase, the DC voltage (V_{B}-V_{DD}) is built between first end N1 and second N2 of the capacitor C_{AC}. When the bootstrapped circuit 100 operates in the "Switch ON (CK=High)" phase, the first end N1 of the capacitor C_{AC} is isolated from the static bias voltage V_{B} and a voltage level of the second end N2 of the capacitor C_{AC} is decreased from V_{DD} to GND. Hence, charge redistribution occurs between the capacitor C_{AC} and parasitic capacitors Cₚₐᵣ, and a voltage level of the first end N1 of the capacitor C_{AC} is decreased from V_{B} to (V_{B}-V_{DD}). In addition to a negative first voltage (e.g., -V_{DD}), a boost voltage (e.g., V_{B}) is applied to the control terminal (e.g., gate) of the MOS transistor MP1. The gate voltage of the MOS transistor MP1 is boosted via AC coupling. Specifically, the MOS transistor MP1 is turned on under a condition that its gate voltage is lower than the second voltage (e.g., GND) and its gate-source voltage V_{gs} is set by a fixed voltage being the negative first voltage (e.g., -V_{DD}).

As a person skilled in the art can readily understand principles and advantages of the bootstrapped switch 600 for a high bias voltage input after reading above paragraphs directed to the bootstrapped switch 100 for a low bias voltage input, further description of the bootstrapped switch 600 is omitted here for brevity.

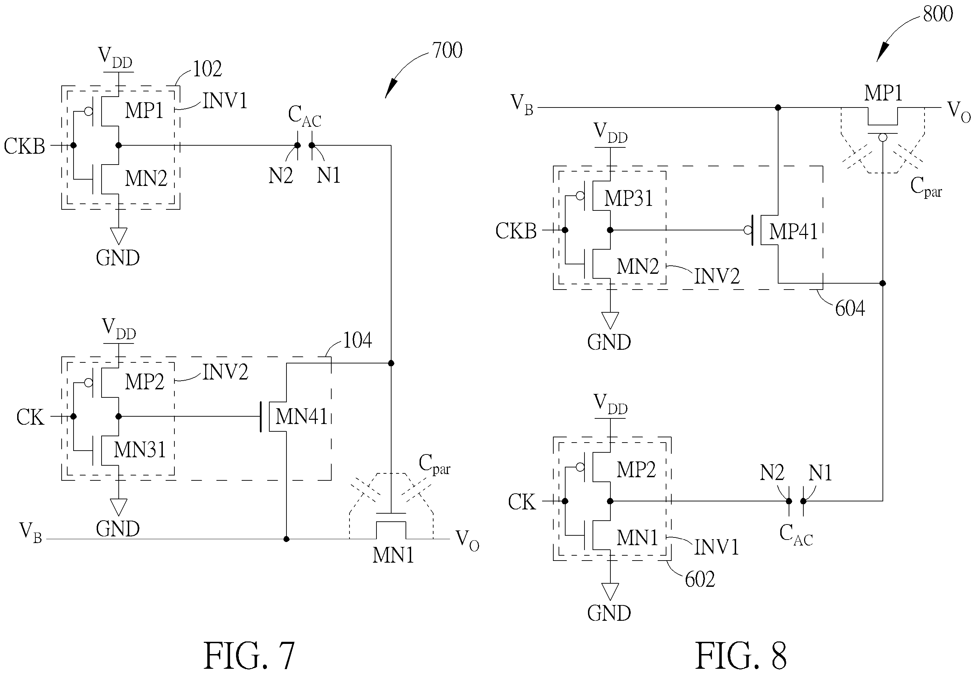

Regarding the bootstrapped switch 100 shown in FIG. 1, the MOS transistor MN3 has the source terminal arranged to receive the static bias voltage V_{B} (which is higher than the ground voltage GND) . Hence, when the MOS transistor MN1 is turned on, the turned-off MOS transistor MN4 has the gate voltage set by V_{B}, the source voltage set by V_{B}, and the drain voltage set by (V_{B}+V_{DD}). In this embodiment, the MOS transistor MN4 may be implemented by a thin oxide device (also called core device). However, this is for illustrative purposes only, and is not meant to be a limitation of the present invention. FIG. 7 is a circuit diagram of a third bootstrapped switch according to an embodiment of the present invention. The difference between the bootstrapped switches 100 and 700 is that the bootstrapped switch 700 uses a MOS transistor MN31 with its first connection terminal (e.g., source) coupled to the first voltage (e.g., GND), and uses a MOS transistor MN41 implemented by a thick oxide device (also called I/O device) . Hence, when the MOS transistor MN1 is turned on, the turned-off MOS transistor MN41 has the gate voltage set by GND, the source voltage set by V_{B}, and the drain voltage set by (V_{B}+V_{DD}). Since the MOS transistor MN41 is implemented by a thick oxide device, the MOS transistor MN41 has no reliability issue in the "Switch ON (CK=High)" phase.

Regarding the bootstrapped switch 600 shown in FIG. 6, the MOS transistor MP3 has the source terminal arranged to receive the static bias voltage V_{B} (which is lower than the supply voltage V_{DD}). Hence, when the MOS transistor MP1 is turned on, the turned-off MOS transistor MP4 has the gate voltage set by V_{B}, the source voltage set by V_{B}, and the drain voltage set by (V_{B}-V_{DD}). In this embodiment, the MOS transistor MP4 may be implemented by a thin oxide device (also called core device). However, this is for illustrative purposes only, and is not meant to be a limitation of the present invention. FIG. 8 is a circuit diagram of a fourth bootstrapped switch according to an embodiment of the present invention. The difference between the bootstrapped switches 600 and 800 is that the bootstrapped switch 800 uses a MOS transistor MP31 with its first connection terminal (e.g., source) coupled to the first voltage (e.g., V_{DD}), and uses a MOS transistor MP41 implemented by a thick oxide device (also called I/O device) . Hence, when the MOS transistor MP1 is turned on, the turned-off MOS transistor MP41 has the gate voltage set by V_{DD}, the source voltage set by V_{B}, and the drain voltage set by (V_{B}-V_{DD}). Since the MOS transistor MP41 is implemented by a thick oxide device, the MOS transistor MP41 has no reliability issue in the "Switch ON (CK=High)" phase.

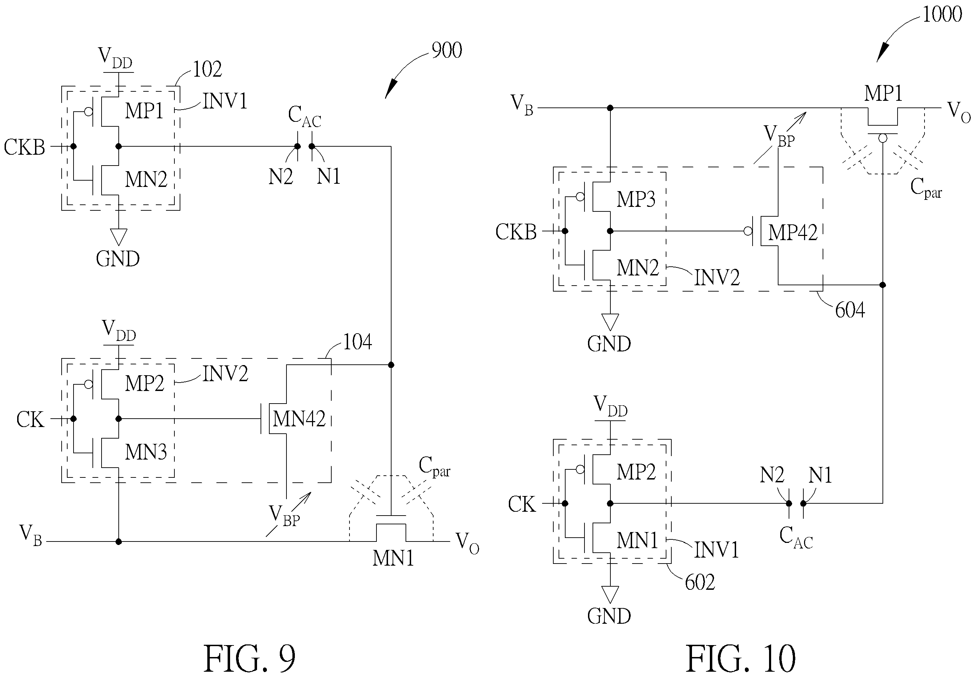

Regarding the bootstrapped switch 100 shown in FIG. 1, the MOS transistor MN4 has the first connection terminal (e.g., source) arranged to receive the static bias voltage V_{B}. Hence, when the MOS transistor MN1 is turned off, the MOS transistor MN4 provides the static bias voltage V_{B} as a boost voltage that is applied to the first end N1 of the capacitor C_{AC}. However, this is for illustrative purposes only, and is not meant to be a limitation of the present invention. FIG. 9 is a circuit diagram of a fifth bootstrapped switch according to an embodiment of the present invention. The difference between the bootstrapped switches 100 and 900 is that the bootstrapped switch 900 uses a MOS transistor MN42 with its first connection terminal (e.g., source) coupled to a programmable boost voltage V_{BP} that is independent of the static bias voltage V_{B} (which is a fixed voltage) . Hence, when the MOS transistor MN1 is turned off, the turned-on MOS transistor MN42 provides the programmable boost voltage V_{BP} to the first end N1 of the capacitor C_{AC}; and when the MOS transistor MN1 is turned on, the gate voltage of the MOS transistor MN1 is set by (V_{BP}+V_{DD}). For example, the programmable boost voltage V_{BP} may be used for calibration purpose.

Regarding the bootstrapped switch 600 shown in FIG. 6, the MOS transistor MP4 has the first connection terminal (e.g., source) arranged to receive the static bias voltage V_{B}. Hence, when the MOS transistor MP1 is turned off, the turned-on MOS transistor MP4 provides the static bias voltage V_{B} as a boost voltage that is applied to the first end N1 of the capacitor C_{AC}. However, this is for illustrative purposes only, and is not meant to be a limitation of the present invention. FIG. 10 is a circuit diagram of a sixth bootstrapped switch according to an embodiment of the present invention. The difference between the bootstrapped switches 600 and 1000 is that the bootstrapped switch 1000 uses a MOS transistor MP42 with its first connection terminal (e.g., source) coupled to a programmable boost voltage V_{BP} that is independent of the static bias voltage V_{B} (which is a fixed voltage) . Hence, when the MOS transistor MP1 is turned off, the turned-on MOS transistor MP42 provides the programmable boost voltage V_{BP} to the first end N1 of the capacitor C_{AC}; and when the MOS transistor MP1 is turned on, the gate voltage of the MOS transistor MP1 is set by (V_{BP}-V_{DD}). For example, the programmable boost voltage V_{BP} may be used for calibration purpose.

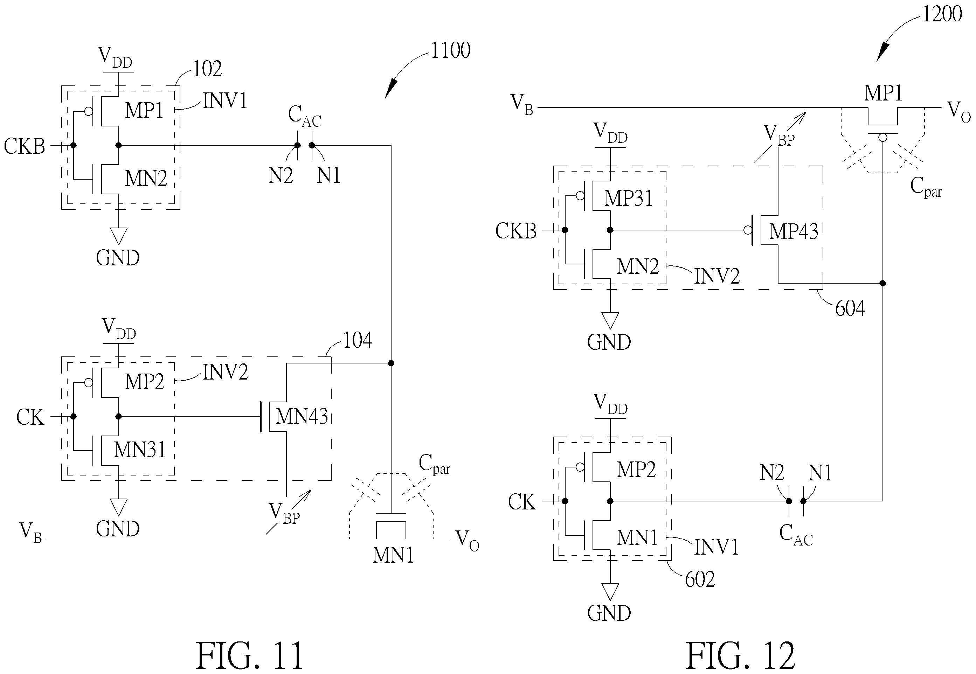

FIG. 11 is a circuit diagram of a seventh bootstrapped switch according to an embodiment of the present invention. The difference between the bootstrapped switches 100 and 1100 is that the bootstrapped switch 1100 uses the MOS transistor MN31 with its first connection terminal (e.g., source) coupled to the first voltage (e.g., GND), and uses a MOS transistor MN43 implemented by a thick oxide device (also called I/O device) and having its first connection terminal (e.g., source) coupled to the programmable boost voltage V_{BP} that is independent of the static bias voltage V_{B} (which is a fixed voltage).

FIG. 12 is a circuit diagram of an eighth bootstrapped switch according to an embodiment of the present invention. The difference between the bootstrapped switches 600 and 1200 is that the bootstrapped switch 1200 uses the MOS transistor MP31 with its first connection terminal (e.g., source) coupled to the first voltage (e.g., V_{DD}), and uses a MOS transistor MP43 implemented by a thick oxide device (also called I/O device) and having its first connection terminal (e.g., source) coupled to the programmable boost voltage V_{BP} that is independent of the static bias voltage V_{B} (which is a fixed voltage).

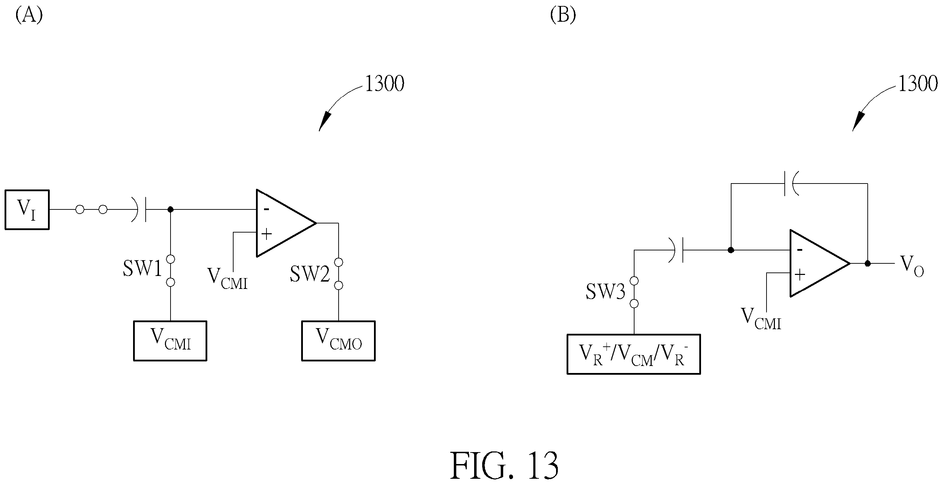

In certain high-speed applications, most MOS switches may be used to conduct constant voltages. Hence, a MOS switch with a static bias voltage input may be implemented using the proposed bootstrapped switch 100/600/700/800/900/1000/1100/1200. FIG. 13 is a diagram of a sample-and-hold (S/H) circuit according to an embodiment of the present invention. When the S/H circuit 1300 operates in a sampling phase as illustrated in sub-diagram (A) of FIG. 13, the MOS switch SW1 is used to conduct a constant voltage V_{CMI}, and the MOS switch SW2 is used to conduct a constant voltage V_{CMO}. Hence, one or both of the MOS switches SW1 and SW2 may be implemented using the proposed bootstrapped switches 100, 600, 700, 800, 900, 1000, 1100, 1200. When the S/H circuit 1300 operates in an amplification/hold phase as illustrated in sub-diagram (B) of FIG. 13, the MOS switch SW3 is used to conduct a constant voltage V_{R}+/V_{CM}/V_{R}-. Hence, the MOS switch SW3 may be implemented using one of the proposed bootstrapped switches 100, 600, 700, 800, 900, 1000, 1100, 1200. However, this is for illustrative purposes only, and is not meant to be a limitation of the present invention. In practice, any application (e.g., high-speed application) using the proposed bootstrapped switch 100/600/700/800/900/1000/1100/1200 falls within the scope of the present invention.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by the following numbered clauses.
1. A bootstrapped switch comprising:
   a first transistor, comprising:
      a first connection terminal, arranged to receive an input voltage of the bootstrapped switch, wherein the input voltage is a static bias voltage;
      a second connection terminal, arranged to generate an output voltage of the bootstrapped switch; and
      a control terminal;
   a capacitor, comprising:
      a first end, coupled to the control terminal of the first transistor; and
      a second end;
   a first voltage providing circuit, coupled to the second end of the capacitor, wherein the first voltage providing circuit is arranged to provide a first voltage to the second end of the capacitor during a first period in which the first transistor is turned off, and provide a second voltage to the second end of the capacitor during a second period in which the first transistor is turned on, where the second voltage is different from the first voltage;
   a second voltage providing circuit, coupled to the control terminal of the first transistor, wherein the second voltage providing circuit is arranged to provide a boost voltage to the control terminal of the first transistor during the first period in which the first transistor is turned off, and stop providing the boost voltage to the control terminal of the first transistor during the second period in which the first transistor is turned on.
2. The bootstrapped switch of clause 1, wherein the first transistor is an N-type transistor.
3. The bootstrapped switch of clause 2, wherein the boost voltage is set by the static bias voltage.
4. The bootstrapped switch of clause 3, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the static bias voltage;
         a second connection terminal; and
         a control terminal, arranged to receive the clock signal; and
   a fourth transistor, comprising:
      a first connection terminal, arranged to receive the static bias voltage;
      a second connection terminal, coupled to the control terminal of the first transistor; and
      a control terminal, coupled to the second connection terminal of the second transistor and the second connection terminal of the third transistor.
5. The bootstrapped switch of clause 3, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the first voltage;
         a second connection terminal; and
         a control terminal, arranged to receive the clock signal; and
   a fourth transistor, comprising:
      a first connection terminal, arranged to receive the static bias voltage;
      a second connection terminal, coupled to the control terminal of the first transistor; and
      a control terminal, coupled to the second connection terminal of the second transistor and the second connection terminal of the third transistor.
6. The bootstrapped switch of clause 2, wherein the boost voltage is set by a programmable boost voltage that is independent of the static bias voltage.
7. The bootstrapped switch of clause 6, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the static bias voltage;
         a second connection terminal; and
         a control terminal, arranged to receive the clock signal; and
   a fourth transistor, comprising:
      a first connection terminal, arranged to receive the programmable boost voltage;
      a second connection terminal, coupled to the control terminal of the first transistor; and
      a control terminal, coupled to the second connection terminal of the second transistor and the second connection terminal of the third transistor.
8. The bootstrapped switch of clause 6, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the first voltage;
         a second connection terminal; and
         a control terminal, arranged to receive the clock signal; and
   a fourth transistor, comprising:
      a first connection terminal, arranged to receive the programmable boost voltage;
      a second connection terminal, coupled to the control terminal of the first transistor; and
      a control terminal, coupled to the second connection terminal of the second transistor and the second connection terminal of the third transistor.
9. The bootstrapped switch of clause 2, wherein the first voltage providing circuit comprises:
   an inverter circuit, comprising:
      a second transistor, comprising:
         a first connection terminal, arranged to receive the second voltage;
         a second connection terminal, coupled to the second end of the capacitor; and
         a control terminal, arranged to receive a clock signal; and
      a third transistor, comprising:
         a first connection terminal, arranged to receive the first voltage;
         a second connection terminal, coupled to the second end of the capacitor; and
         a control terminal, arranged to receive the clock signal.
10. The bootstrapped switch of clause 1, wherein the first transistor is a P-type transistor.
11. The bootstrapped switch of clause 10, wherein the boost voltage is set by the static bias voltage.
12. The bootstrapped switch of clause 11, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the static bias voltage;
         a second connection terminal; and
         a control terminal, arranged to receive the clock signal; and
   a fourth transistor, comprising:
      a first connection terminal, arranged to receive the static bias voltage;
      a second connection terminal, coupled to the control terminal of the first transistor; and
      a control terminal, coupled to the second connection terminal of the second transistor and the second connection terminal of the third transistor.
13. The bootstrapped switch of clause 11, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the first voltage;
         a second connection terminal; and
         a control terminal, arranged to receive the clock signal; and
   a fourth transistor, comprising:
      a first connection terminal, arranged to receive the static bias voltage;
      a second connection terminal, coupled to the control terminal of the first transistor; and
      a control terminal, coupled to the second connection terminal of the second transistor and the second connection terminal of the third transistor.
14. The bootstrapped switch of clause 10, wherein the boost voltage is set by a programmable boost voltage that is independent of the static bias voltage.
15. The bootstrapped switch of clause 14, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the static bias voltage;
         a second connection terminal; and
         a control terminal, arranged to receive the clock signal; and
   a fourth transistor, comprising:
      a first connection terminal, arranged to receive the programmable boost voltage;
      a second connection terminal, coupled to the control terminal of the first transistor; and
      a control terminal, coupled to the second connection terminal of the second transistor and the second connection terminal of the third transistor.
16. The bootstrapped switch of clause 14, wherein the second voltage providing circuit comprises:
   an inverter circuit, comprising:
      a second transistor, comprising:
         a first connection terminal, arranged to receive the second voltage;
         a second connection terminal; and
         a control terminal, arranged to receive a clock signal;
      a third transistor, comprising:
         a first connection terminal, arranged to receive the first voltage;
         a second connection terminal; and
         a control terminal, arranged to receive the clock signal; and
   a fourth transistor, comprising:
      a first connection terminal, arranged to receive the programmable boost voltage;
      a second connection terminal, coupled to the control terminal of the first transistor; and
      a control terminal, coupled to the second connection terminal of the second transistor and the second connection terminal of the third transistor.
17. The bootstrapped switch of clause 10, wherein the first voltage providing circuit comprises:
   an inverter circuit, comprising:
      a second transistor, comprising:
         a first connection terminal, arranged to receive the second voltage;
         a second connection terminal, coupled to the second end of the capacitor; and
         a control terminal, arranged to receive a clock signal; and
      a third transistor, comprising:
         a first connection terminal, arranged to receive the first voltage;
         a second connection terminal, coupled to the second end of the capacitor; and
         a control terminal, arranged to receive the clock signal.
18. A sample-and-hold circuit comprising the bootstrapped switch of clause 1.

## Claims

1. A bootstrapped switch (100, 600, 700, 800, 900, 1000, 1100, 1200) comprising:
a first transistor (MN1), comprising:
a first connection terminal, arranged to receive an input voltage of the bootstrapped switch (100, 600, 700, 800, 900, 1000, 1100, 1200), wherein the input voltage is a static bias voltage (V_{B});
a second connection terminal, arranged to generate an output voltage of the bootstrapped switch (100, 600, 700, 800, 900, 1000, 1100, 1200); and
a control terminal;
a capacitor (C_{AC}), comprising:
a first end (N1), coupled to the control terminal of the first transistor (MN1); and
a second end (N2);
a first voltage providing circuit (102, 602), coupled to the second end (N2) of the capacitor (C_{AC}), wherein the first voltage providing circuit (102, 602) is arranged to provide a first voltage to the second end (N2) of the capacitor (C_{AC}) during a first period in which the first transistor (MN1)is turned off, and provide a second voltage to the second end (N2) of the capacitor (C_{AC}) during a second period in which the first transistor (MN1) is turned on, where the second voltage is different from the first voltage;
a second voltage providing circuit (104, 604), coupled to the control terminal of the first transistor (MN1), wherein the second voltage providing circuit (104, 604) is arranged to provide a boost voltage to the control terminal of the first transistor (MN1) during the first period in which the first transistor (MN1) is turned off, and stop providing the boost voltage to the control terminal of the first transistor (MN1) during the second period in which the first transistor (MN1) is turned on.

2. The bootstrapped switch (100, 600, 700, 800, 900, 1000, 1100, 1200) of claim 1, wherein the first transistor (MN1) is an N-type transistor.

3. The bootstrapped switch (100, 600, 700, 800, 900, 1000, 1100, 1200) of claim 2, wherein the boost voltage is set by the static bias voltage (V_{B}).

4. The bootstrapped switch (100, 600, 700, 800, 900, 1000, 1100, 1200) of claim 3, wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the static bias voltage (V_{B});
a second connection terminal; and
a control terminal, arranged to receive the clock signal (CKB); and
a fourth transistor (MN4), comprising:
a first connection terminal, arranged to receive the static bias voltage (V_{B});
a second connection terminal, coupled to the control terminal of the first transistor (MN1); and
a control terminal, coupled to the second connection terminal of the second transistor (MN2) and the second connection terminal of the third transistor (MN3).

5. The bootstrapped switch (100, 600, 700, 800, 900, 1000, 1100, 1200) of claim 3, wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the first voltage;
a second connection terminal; and
a control terminal, arranged to receive the clock signal (CKB); and
a fourth transistor (MN4), comprising:
a first connection terminal, arranged to receive the static bias voltage (V_{B});
a second connection terminal, coupled to the control terminal of the first transistor (MN1); and
a control terminal, coupled to the second connection terminal of the second transistor (MN2) and the second connection terminal of the third transistor (MN3).

6. The bootstrapped switch (100, 600, 700, 800, 900, 1000, 1100, 1200) of claim 2, wherein the boost voltage is set by a programmable boost voltage (V_{BP}) that is independent of the static bias voltage (V_{B}).

7. The bootstrapped switch (100, 600, 700, 800, 900, 1000, 1100, 1200) of claim 6, wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the static bias voltage (V_{B});
a second connection terminal; and
a control terminal, arranged to receive the clock signal (CKB); and
a fourth transistor (MN4), comprising:
a first connection terminal, arranged to receive the programmable boost voltage (V_{BP}) ;
a second connection terminal, coupled to the control terminal of the first transistor (MN1); and
a control terminal, coupled to the second connection terminal of the second transistor (MN2) and the second connection terminal of the third transistor (MN3); or
wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the first voltage;
a second connection terminal; and
a control terminal, arranged to receive the clock signal (CKB); and
a fourth transistor (MN4), comprising:
a first connection terminal, arranged to receive the programmable boost voltage (V_{BP}) ;
a second connection terminal, coupled to the control terminal of the first transistor (MN1); and
a control terminal, coupled to the second connection terminal of the second transistor (MN2) and the second connection terminal of the third transistor (MN3).

8. The bootstrapped switch (100, 600, 700, 800, 900, 1000, 1100, 1200) of claim 2, wherein the first voltage providing circuit (102, 602) comprises:
an inverter circuit (INV1, INV2), comprising:
a second transistor (MN2), comprising:
a first connection terminal, arranged to receive the second voltage;
a second connection terminal, coupled to the second end (N2) of the capacitor (C_{AC}); and
a control terminal, arranged to receive a clock signal (CKB); and
a third transistor (MN3), comprising:
a first connection terminal, arranged to receive the first voltage;
a second connection terminal, coupled to the second end (N2) of the capacitor (C_{AC}); and
a control terminal, arranged to receive the clock signal (CKB).

9. The bootstrapped switch (100, 600, 700, 800, 900, 1000, 1100, 1200) of claim 1, wherein the first transistor (MN1) is a P-type transistor.

10. The bootstrapped switch (100, 600, 700, 800, 900, 1000, 1100, 1200) of claim 9, wherein the boost voltage is set by the static bias voltage (V_{B}).

11. The bootstrapped switch (100, 600, 700, 800, 900, 1000, 1100, 1200) of claim 10, wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the static bias voltage (V_{B});
a second connection terminal; and
a control terminal, arranged to receive the clock signal (CKB); and
a fourth transistor (MN4), comprising:
a first connection terminal, arranged to receive the static bias voltage (V_{B});
a second connection terminal, coupled to the control terminal of the first transistor (MN1); and
a control terminal, coupled to the second connection terminal of the second transistor (MN2) and the second connection terminal of the third transistor (MN3); or
wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the first voltage;
a second connection terminal; and
a control terminal, arranged to receive the clock signal (CKB); and
a fourth transistor (MN4), comprising:
a first connection terminal, arranged to receive the static bias voltage (V_{B});
a second connection terminal, coupled to the control terminal of the first transistor (MN1); and
a control terminal, coupled to the second connection terminal of the second transistor (MN2) and the second connection terminal of the third transistor (MN3).

12. The bootstrapped switch (100, 600, 700, 800, 900, 1000, 1100, 1200) of claim 9, wherein the boost voltage is set by a programmable boost voltage (V_{BP}) that is independent of the static bias voltage (V_{B}).

13. The bootstrapped switch (100, 600, 700, 800, 900, 1000, 1100, 1200) of claim 12, wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the static bias voltage (V_{B});
a second connection terminal; and
a control terminal, arranged to receive the clock signal (CKB); and
a fourth transistor (MN4), comprising:
a first connection terminal, arranged to receive the programmable boost voltage (V_{BP}) ;
a second connection terminal, coupled to the control terminal of the first transistor (MN1); and
a control terminal, coupled to the second connection terminal of the second transistor (MN2) and the second connection terminal of the third transistor (MN3); or
wherein the second voltage providing circuit (104, 604) comprises:
an inverter circuit (INV1, INV2), comprising:
a second transistor (MN2), comprising:
a first connection terminal, arranged to receive the second voltage;
a second connection terminal; and
a control terminal, arranged to receive a clock signal (CKB);
a third transistor (MN3), comprising:
a first connection terminal, arranged to receive the first voltage;
a second connection terminal; and
a control terminal, arranged to receive the clock signal (CKB); and
a fourth transistor (MN4), comprising:
a first connection terminal, arranged to receive the programmable boost voltage (V_{BP}) ;
a second connection terminal, coupled to the control terminal of the first transistor (MN1); and
a control terminal, coupled to the second connection terminal of the second transistor (MN2) and the second connection terminal of the third transistor (MN3).

14. The bootstrapped switch (100, 600, 700, 800, 900, 1000, 1100, 1200) of claim 9, wherein the first voltage providing circuit (102, 602) comprises:
an inverter circuit (INV1, INV2), comprising:
a second transistor (MN2), comprising:
a first connection terminal, arranged to receive the second voltage;
a second connection terminal, coupled to the second end (N2) of the capacitor (C_{AC}); and
a control terminal, arranged to receive a clock signal (CKB); and
a third transistor (MN3), comprising:
a first connection terminal, arranged to receive the first voltage;
a second connection terminal, coupled to the second end (N2) of the capacitor (C_{AC}); and
a control terminal, arranged to receive the clock signal (CKB).

15. A sample-and-hold circuit comprising the bootstrapped switch (100, 600, 700, 800, 900, 1000, 1100, 1200) of claim 1.
